# EUROPEAN PATENT SPECIFICATION

(11) **EP 3 607 634 B1**
(45) Date of publication and mention of the grant of the patent: **07.06.2023**
(21) Application number: 18780937.1
(22) Date of filing: 23.03.2018
(51) Int. Cl.: F25D 29/00, G08C 21/00, G08B 13/14

(54) **METHOD AND APPARATUS FOR MONITORING SUPPLY OF ELECTRICITY**
VERFAHREN UND VORRICHTUNG ZUR ÜBERWACHUNG DER ELEKTRIZITÄTSVERSORGUNG
PROCÉDÉ ET APPAREIL DE SURVEILLANCE D'APPROVISIONNEMENT EN ÉLECTRICITÉ

(30) Priority: 03.04.2017 FI 20175307
(43) Date of publication of application: 12.02.2020
(73) Proprietor: Nordic 24/7 Services Oy, 02200 Espoo (FI)
(72) Inventor: ELORANTA, Veli, 00350 Helsinki (FI)
(74) Representative: Laine IP Oy
(86) International application number: PCT/FI2018/050222
(87) International publication number: WO 2018/185365

(56) References cited:
- DE-A1-102006 029 427
- US-A1- 2010 228 425
- US-A1- 2013 335 223
- US-A1- 2016 147 209
- US-B1- 7 893 686

## Description

### Background

Various devices, such as refrigerators, freezers and coolers, use electricity. Supply of electricity may be interrupted for various reasons. There is, therefore, a need for monitoring the supply of electricity.

US2013335223 discloses a method and a system of deterring theft of an electronic device connected to an external source of charging power. Electronic device includes theft deterrent program, embedded controller, power controller, main battery, and backup power DC source 180. While the electronic device is armed, the electronic device detects loss of the connection to the source of charging power, and in response, the electronic device activates an alarm or notifies another computing device that the electronic device has been disconnected from the source of charging power.

### Summary

Various aspects of the invention include an apparatus and a system, and a computer readable medium comprising a computer program stored therein, which are characterized by what is stated in the independent claims. Various embodiments of the invention are disclosed in the dependent claims.

### Description of the Drawings

In the following, various embodiments of the invention will be described in more detail with reference to the appended drawings, in which
- Fig. 1: shows, by way of example, an apparatus for monitoring electricity supply;
- Fig. 2a: shows, by way of example, an apparatus for monitoring electricity supply;
- Fig. 2b: shows, by way of example, a block diagram of a control unit of an apparatus for monitoring electricity supply;
- Fig. 3: shows, by way of example, a system for monitoring electricity supply;
- Fig. 4: shows, by way of example, a block diagram of a monitoring apparatus;
- Fig. 5: shows, by way of example, a method for monitoring electricity supply; and
- Fig. 6: shows, by way of example, a method for monitoring electricity supply,

The drawings are schematic.

### Description of Example Embodiments

In the following, several embodiments of the invention will be described in the context of beverage coolers. It is to be noted, however, that the invention is not limited to beverage coolers. In fact, the different embodiments have applications in any environment where monitoring the supply of electricity is required.

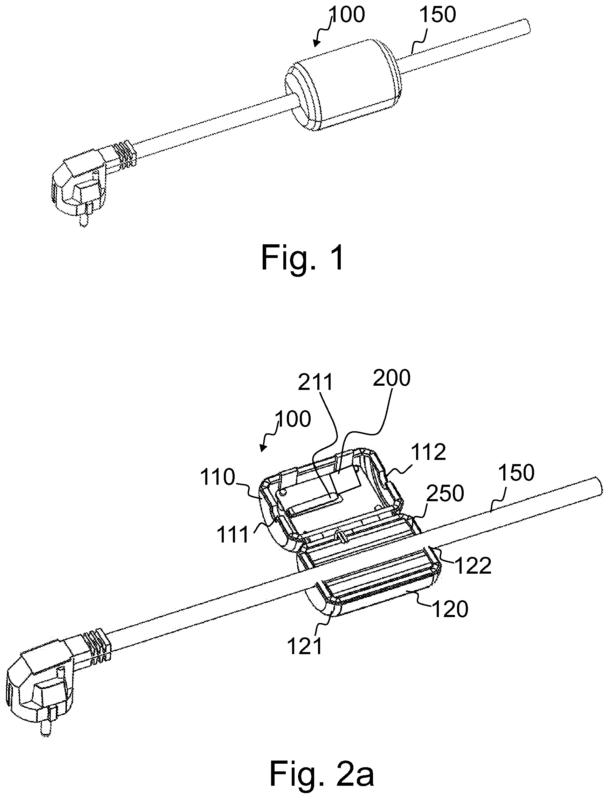

Fig. 1 shows, by way of example, an apparatus for monitoring electricity supply. The monitoring apparatus 100 is a voltage detection means installed over a power cord 150.

The power cord 150 may be a power cord of any equipment, e.g. a cooler equipment such as a freezer or a refrigerator. Installation of the monitoring apparatus 100 may be carried out by a person not having any specific qualification of electrician or equivalent. The monitoring apparatus 100 need not have any galvanic connection to the electric parts of the power cord 150. The monitoring apparatus 100 may be installed such that it surrounds the power cord 150. The installation may be tight enough such that the monitoring apparatus 100 does not slide along the power cord 150.

Fig. 2a shows, by way of example, the apparatus for monitoring electricity supply. The monitoring apparatus 100 may have a top cover 110 and a bottom cover 120. The top cover 110 and the bottom cover 120 may be hingedly attached to each other. In a closed position, such as in Fig. 1, the monitoring apparatus 100 may have a form of cylinder. Alternatively, the form of the monitoring apparatus may be e.g. spherical or prism. The top cover 110 and the bottom cover 120 form a chamber when the covers are in the closed position. The formed chamber is a hollow space wherein e.g. a control unit 200 and one or more battery 250 may be assembled. The monitoring apparatus may comprise one or more battery 250 for supplying power to e.g. a sensor unit 210 and/or to a positioning module 220. The top cover 110 and the bottom cover 120 may have openings 111, 112, 121, 122 for receiving the power cord 150. The power cord may be squeezed between the openings such that the monitoring apparatus 100 does not slide along the power cord 150.

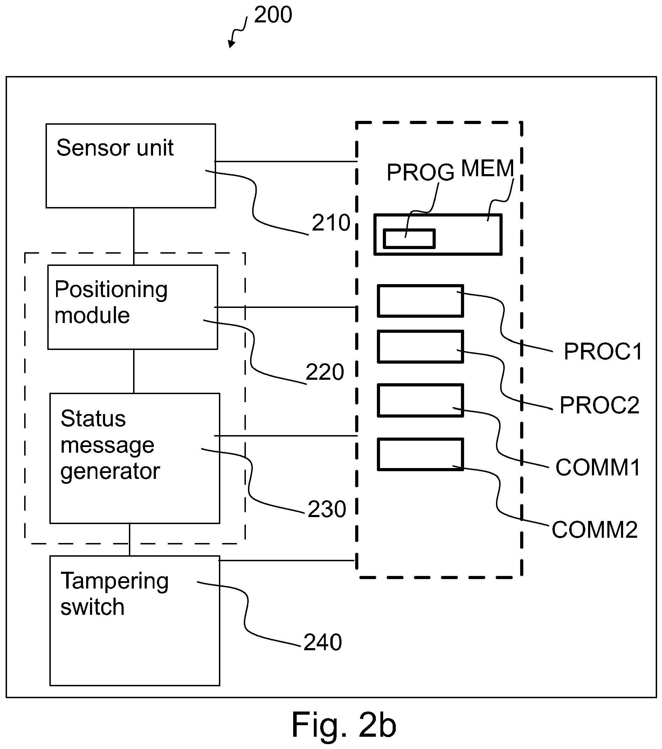

Fig. 2b shows, by way of example, a block diagram of the control unit of the monitoring apparatus. The monitoring apparatus comprises the control unit 200. The control unit 200 may comprise memory MEM. The control unit 200 may comprise computer program code PROG residing in the memory MEM for implementing, for example, monitoring electricity supply. The control unit 200 may comprise one or more processors PROC1, PROC2 that, when running the computer program code PROG, causes the monitoring apparatus to carry out the method as disclosed herein. The control unit 200 may comprise communication modules COMM1, COMM2 for communicating with other devices. The control unit 200 may comprise circuitry and electronics for handling, receiving and transmitting data. The control unit 200 may comprise or may be connected to these elements, or fewer or more elements. The elements of the control unit 200 may be connected with each other.

The monitoring apparatus comprises a sensor unit 210 for detecting electric field in the power cord. The sensor may be configured to monitor voltage in the electricity supply means of the device, e.g. beverage cooler. The electricity supply means is a power cord. The sensor is configured to detect a loss of voltage. A magnetic field is produced around a power cord (conductor) carrying a current. If the current is alternating current, the magnetic field produced around the power cord varies periodically. The sensor 210 may comprise e.g. one or more transistors for detecting the changing magnetic field. The transistor may be e.g. a NPN type transistor. The sensor may comprise an antenna 211 (see Fig. 2a). A current will be induced into the antenna from the power cord carrying the current due to electromagnetic induction. The antenna is connected to the transistor and the current triggers the transistor on. If the electricity in the power cord is cut off, the transistor is triggered off. The transistor may act as a switch.

The antenna 211 may function as a spring for producing a compressive force against the power cord 150. Size, i.e. diameter of the power cord may vary, and the compressive force of the spring helps to prevent the sliding of the monitoring apparatus along the power cord.

There may be situations where the electricity in the power cord is cut off. The electricity in the power cord may be cut off e.g. because of a power failure or if the power cord is removed from a power socket. The sensor 210 may detect a loss of voltage. The loss of voltage may be detected if the monitoring apparatus 100 is removed from the power cord. Indication that the loss of voltage has been detected may be stored in the memory MEM.

The monitoring apparatus 100 may comprise a switch 240. The switch may be a tampering switch. The control unit 220 may be connected to or comprise the tampering switch 240. The tampering switch may be a micro switch i.e. a miniature snap-action switch. The micro switch is an electric switch that is actuated by small physical force through the use of a tipping-point mechanism. The tampering switch may detect if the cover 110, 120 of the monitoring apparatus 100 is opened or closed. If the cover 110, 120 of the monitoring apparatus 100 is opened and/or the monitoring apparatus is removed from the power cord 150, loss of voltage may be detected. The status of the tampering switch may be read and stored in the memory MEM. The status of the tampering switch may be reported as a part of a status message as described below.

The monitoring apparatus may be configured to operate in a monitoring state and in an active state. During the monitoring state the sensor unit is detecting voltage. Current consumption of the monitoring apparatus during the monitoring state is estimated to be low, approximately 10µA in average. Thus, the use of the monitoring apparatus is environmentally friendly. If the loss of voltage occurs, the monitoring apparatus is configured to operate in the active state, which is described below.

In addition to monitoring the supply of electricity of beverage coolers, it is beneficial to know location of the cooler which is out of electricity and/or the monitoring apparatus of which has been opened. Beverage coolers in restaurants or cafés are usually provided by a beverage distributor without direct costs. If a restaurant or a café closes its business, the beverage cooler may be e.g. given to someone or may get lost for some other reason. If the beverage cooler ends up to environment, it will be harmful for the nature.

The monitoring apparatus comprises a positioning module 220. The control unit 200 may be connected to or may comprise the positioning module 220. If the loss of voltage has occurred, the positioning module 220 is configured to activate in response to the detected loss of voltage. Activating means that the positioning module is powered up. If the positioning module is already powered up, the activating means that the positioning module is requested to acquire positioning information. The sensor 210 may switch the positioning module on in response to the detected loss of voltage. When the positioning module is switched on, the monitoring apparatus is in the active state. Since the positioning module is powered off, i.e. in a sleep mode, during monitoring state when there is no loss of voltage detected, the power consumption of the monitoring apparatus may be decreased. The loss of voltage may trigger the powering up of the positioning module.

The positioning module may be activated in a certain time after the loss of voltage has been detected if the loss of voltage is still detected after the certain time. This is beneficial, since a short and unharmful power failure may occur, and it may be unnecessary to activate the positioning module if the voltage is restored shortly. The certain time i.e. delay may be determined by a user. The delay may be provided through a user interface as an input.

When the positioning module is activated, the positioning module is configured to acquire positioning information of the monitoring apparatus. The positioning information may be acquired e.g. using network-based techniques and/or satellite navigation systems, such as GPS, Galileo or GLONASS. The positioning information may be acquired using e.g. triangulation or multilateration. Triangulation is a process of determining a location of a point by forming triangles to it from known points, e.g. three known base stations. Coordinates (latitude and longitude) of the beverage cooler may be determined using the positioning information. Alternatively or in addition, self-reported positioning may be used such that the user determines the position of the beverage cooler when installing the monitoring apparatus over the power cord of the beverage cooler. The user may provide the original installation position as an input to the monitoring apparatus. The input may be provided through a user interface. The monitoring apparatus may comprise or may be connected to the user interface. The user interface may receive user input through a touch screen and/or a keypad. The positioning module may be connected to the memory MEM. The positioning information may be stored in the memory MEM.

Alternatively or in addition to the network based techniques described above, the positioning information may be acquired from the memory MEM. The positioning module may be configured to acquire positioning information at certain time intervals, e.g. once a day or every hour and store the positioning information in the memory MEM. When the positioning module activates, the positioning information, e.g. the latest acquired positioning information, may be acquired from the memory MEM.

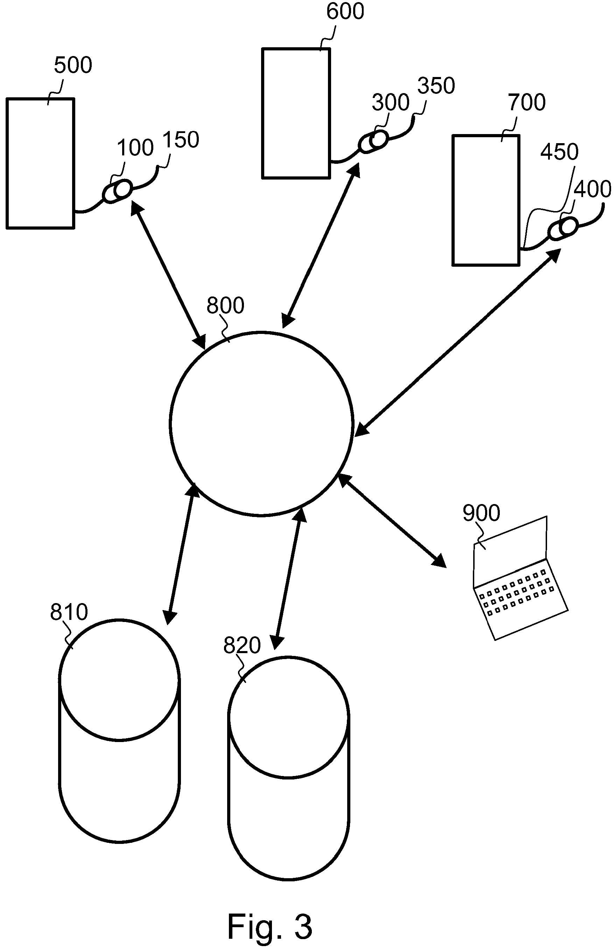

When the loss of voltage occurs and is detected, the positioning module activates and the monitoring apparatus is in active state. During the active state the monitoring apparatus may provide status information on the monitoring apparatus to a database 810, 820 (see Fig. 3). The sensor may be active during the active state.

The monitoring apparatus may comprise a status message generator 230. The control unit 200 may be connected to or may comprise the status message generator 230. The positioning module may be connected to or may comprise the status message generator. The status message generator may receive data from the memory MEM. The data may comprise e.g. the positioning information and/or the status of the tampering switch and/or information that the voltage loss has been detected. The status message generator may generate the status message based on the data received from the memory MEM. The monitoring apparatus may transmit a status message. The positioning module is configured to transmit the status message using the communication module COMM1, COMM2. The status message may be transmitted to a remote unit. The remote unit may be e.g. the database 810, 820 or the user device 900 (see Fig. 3). The status message comprises at least the positioning information. The positioning information may be used to determine which beverage cooler may be out of electric supply. The positioning information may be used to determine if the beverage cooler is moved from its location, e.g. stolen.

The status message may comprise a time stamp. The time stamp may be UTC time received from a cellular network. The time stamp may be stored in the memory MEM.

The status message may be provided once or the status message may be sent at certain time intervals. Time interval between the message transmissions may be set to e.g. 30 - 60 min. Between the transmissions the positioning module may be powered off. The power consumption may be decreased by keeping the positioning module in the sleep mode between the transmissions.

The status message may comprise device authentication data. The status message may comprise information that the voltage loss has been detected. The status message may comprise a reason for the voltage loss. For example, the monitoring apparatus may have been removed from the power cord and it may be detected using the tampering switch. The tampering switch is arranged to detect if the cover of the monitoring apparatus is opened or closed. If the tampering switch detects that the cover of the monitoring apparatus is opened, it may be determined that the loss of voltage occurred because of the removal of the monitoring apparatus from the power cord. This means that the beverage cooler is not necessarily out of electricity. Using the positioning information it may be determined where the beverage cooler is and the situation of the beverage cooler may be checked out by maintenance personnel. The status message may comprise information on battery 250 level of the monitoring apparatus 100 and/or low battery alert. The status message may comprise initial installation position of the beverage cooler. The status message may comprise indication that the positioning module is powered off to sleep mode.

If the cause of the detected voltage loss is removed and restoration of voltage is detected by the monitoring apparatus, the monitoring apparatus may acquire positioning information of the monitoring apparatus and transmit the status message comprising at least the positioning information to the remote unit. When the status message has been transmitted to the remote unit which saves it in the database, the positioning module may be deactivated in response to the transmitting of the status message. Deactivating means that the positioning module is powered off. The powering off may be triggered by the providing of the status message. This may ensure that sending of the status message is carried out before the positioning module is powered off. The status message may comprise the data described above. The status message may comprise indication that the voltage is detected i.e. restored. The status message may comprise indication that the positioning module is powered off to sleep mode. The power consumption may be decreased by returning the positioning module into sleep mode. A time delay, e.g. of half an hour, or 1 hour, may be set for deactivation. This means that after the restoration of voltage has been detected, the device may be in active state for 1 hour before returning to the monitoring state.

Fig. 3 shows, by way of example, a system for monitoring electricity supply. The system may be a service system for monitoring and keeping track of beverage coolers. The system comprises one or more voltage detection means. The voltage detection means may comprise, for example, the sensor unit in the monitoring apparatus 100, 300, 400. The electricity supply means 150, 350, 450, e.g. the power cord, of the devices 500, 600, 700 may be provided with the voltage detection means. The one or more monitoring apparatus 100, 300, 400 are attached over the power cords of the devices 500, 600, 700. The device 500, 600, 700 may be e.g. a beverage cooler or a freezer. The one or more monitoring apparatus 100, 300, 400 may be connected through a communication connection to a network 800, e.g. a cellular network or Internet. The communication connection may be e.g. a wireless cellular communication network or a wireless local area network. The system may comprise one or more databases 810, 820. The databases may be connected through a communication connection to the network 800. The database 810, 820 may be implemented in one or more servers and together they may form a server system such as a cloud. The database 810, 820 may receive positioning information and/or status message(s) from the monitoring apparatus 100, 300, 400. The system may comprise a user device 900. The user device 900 may be connected through a communication connection to the network 800. The user device may comprise the user interface of the monitoring apparatus. The user device may be e.g. a personal computer or a smartphone. The user device 900 may receive the positioning information and/or status message(s) from the database and/or the user device 900 may be used to access the positioning information and/or status message(s) in the database.

When the devices 500, 600, 700 are installed, the monitoring apparatuses 100, 300, 400 may be paired with corresponding devices 500, 600, 700. The pairing may be carried out e.g. by scanning a bar code from the monitoring apparatus and entering details of the device to the service system using the user device 900. Details may comprise e.g. a serial number of a beverage cooler, model of the beverage cooler and/or a name of the possessor of the beverage cooler and/or a user responsible of the maintenance of the beverage cooler.

When installing the monitoring apparatus 100 over the power cord of the device for the first time, the positioning module may be powered on and configured to acquire positioning information and to provide the original installation position of the device to the service system. After sending at least the original installation position to the service system, the positioning module may be powered off to sleep mode.

The remote unit is configured to receive the status message(s) from the monitoring apparatus 100, 300, 400. The status message comprises at least the positioning information of the monitoring apparatus. The remote unit is configured to determine based on the positioning information that loss of voltage has occurred in the power cord of the device 500, 600, 700. The remote unit may be configured to form a map showing a location of the monitoring apparatus based on the positioning information. The map (without location information of the monitoring apparatuses) may be a digital map received from a web mapping service, e.g. Bing^{®} Maps or Google^{®} Maps. Web mapping is a process of using maps delivered by geographic information systems (GIS). The remote unit may be configured to show the formed map showing location(s) of the monitoring apparatus(es) to the user, e.g. the maintenance personnel and/or the owner of the device 500, 600, 700. The map may be showed e.g. on a screen of the user device 900.

The view on the map may be modified according to needs of the user. It may be selected to show on the map e.g. the devices that have been moved from the original installation location, the devices with which a voltage loss has occurred, the devices with low battery status, the devices that have reported tampering, or all the devices in the service system. At least part of the information received in the status message(s) may be delivered to the user e.g. the maintenance personnel and/or the owner of the device. The information may be delivered e.g. as a text message, e-mail, or as an automated phone call.

It is possible to remove a device from the service system. For example, the beverage cooler may have been returned to a warehouse of the owner. The device may be unpaired from the monitoring apparatus. The device and the monitoring apparatus may be unpaired automatically, if it is determined based on the received positioning information that the monitoring apparatus is located in the warehouse or at the proximity of the warehouse. The proximity settings may be defined by the user.

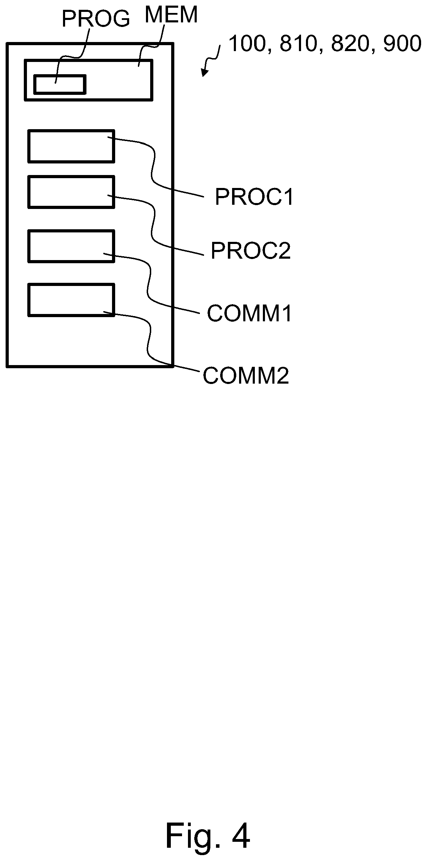

Fig. 4 shows, by way of example, a block diagram of the monitoring apparatus 100, the databases 810, 820, and/or the user device 900. The monitoring apparatus, the databases 810, 820, and/or the user device 900 may comprise memory MEM. The monitoring apparatus, the databases 810, 820, and/or the user device 900 may comprise computer program code PROG residing in the memory MEM for implementing, for example, monitoring electricity supply. The monitoring apparatus, the databases 810, 820, and/or the user device 900 may comprise one or more processors PROC1, PROC2 that, when running the computer program code PROG, causes the apparatuses to carry out the method(s) as disclosed herein. The monitoring apparatus, the databases 810, 820, and/or the user device 900 may comprise communication modules COMM1, COMM2 for communicating with other devices. The monitoring apparatus, the databases 810, 820, and/or the user device 900 may comprise circuitry and electronics for handling, receiving and transmitting data. The monitoring apparatus, the databases 810, 820, and/or the user device 900 may comprise these elements, or fewer or more elements.

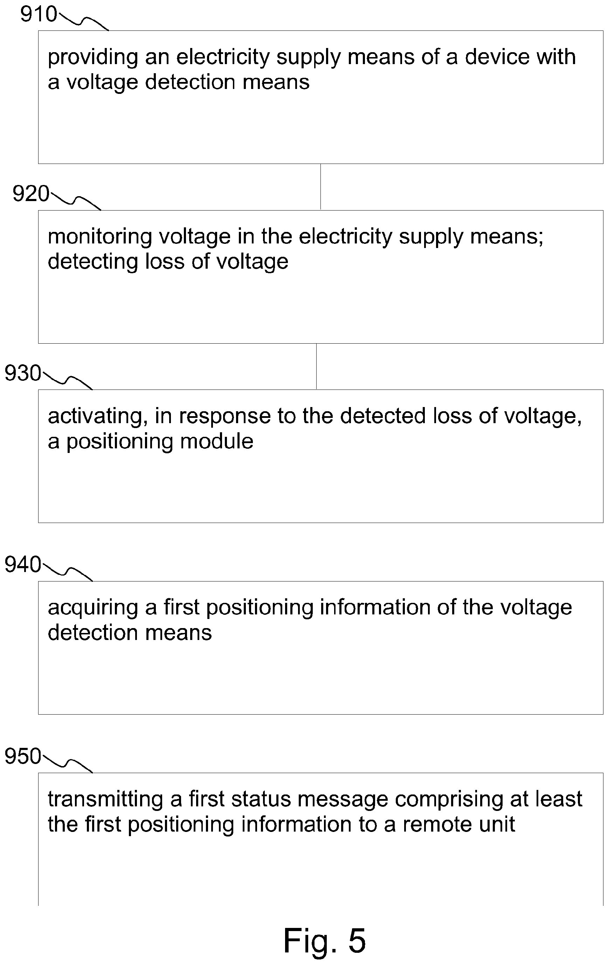

Fig. 5 shows, by way of example, a method for monitoring electricity supply. The method comprises providing 910 an electricity supply means of a device with a voltage detection means, monitoring 920 voltage in the electricity supply means, detecting loss of voltage, activating 930, in response to the detected loss of voltage, a positioning module, acquiring 940 a first positioning information of the voltage detection means. The positioning information acquired in response to the detected loss of voltage is the first positioning information. The method further comprises transmitting 950 a first status message comprising at least the first positioning information to a remote unit. The status message transmitted in response to the detected loss of voltage is the first status message.

According to an embodiment, the method may comprise detecting restoration of voltage. The method may comprise acquiring, in response to the detected restoration of voltage, a second positioning information of the voltage detection means. The positioning information acquired in response to the detected restoration of voltage is the second positioning information. The first positioning information may be the same as the second positioning information if the monitoring apparatus has not been moved. The method may comprise transmitting a second status message comprising at least the second positioning information to the remote unit. The status message transmitted in response to the restoration of voltage is the second status message. The method may comprise deactivating, in response to the transmitting of the second status message, the positioning module.

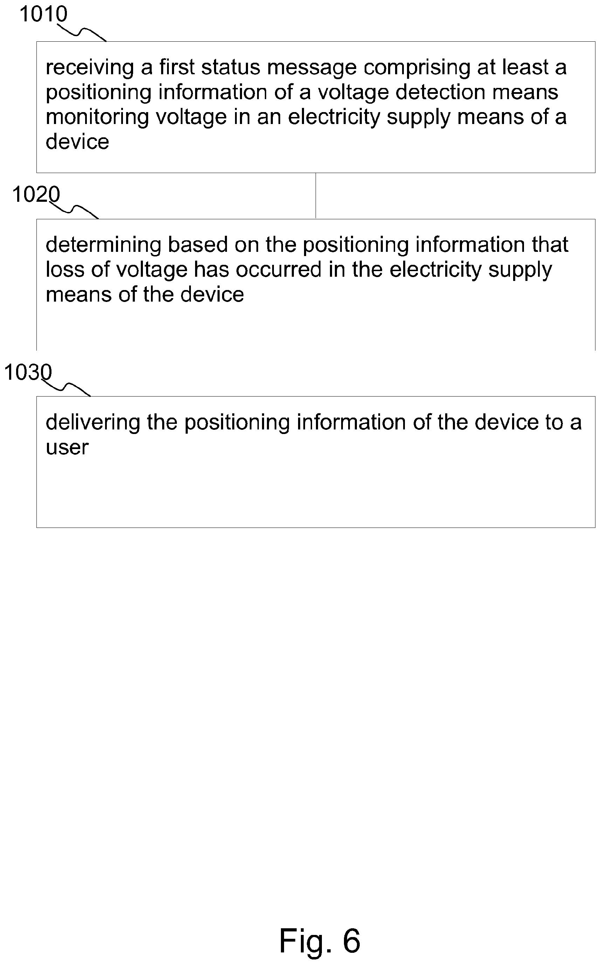

Fig. 6 shows, by way of example, a method for monitoring electricity supply. The method comprises receiving 1010 a status message comprising at least a positioning information of a voltage detection means monitoring voltage in an electricity supply means of a device, determining 1020 based on the positioning information that loss of voltage has occurred in the electricity supply means of the device, and delivering 1030 the positioning information of the device to a user.

It is obvious that the present invention is not limited solely to the above-presented embodiments, but it can be modified within the scope of the appended claims.

## Claims

1. An apparatus (100), installable over a power cord of a device, comprising:
a sensor unit (210) configured to monitor voltage in the power cord (150) of the device (500) and to detect loss of voltage in the power cord;
a positioning module (220) configured to
be in a sleep mode when the voltage in the power cord is monitored;
activate in response to the detected loss of voltage;
acquire a first positioning information of the apparatus (100); and
transmit a first status message comprising at least the first positioning information to a remote unit (810).

2. The apparatus (100) according to claim 1, wherein
the sensor unit (210) is further configured to detect restoration of voltage in the power cord;
the positioning module (220) is further configured to
acquire, in response to the detected restoration of voltage, a second positioning information of the apparatus (100);
transmit a second status message comprising at least the second positioning information to the remote unit (810);
deactivate, in response to the transmitting of the second status message, the positioning module (220).

3. The apparatus (100) according to claim 1 or 2, further comprising a cover (110);
a switch (240) configured to detect if the cover (110) of the apparatus (100) is open; and wherein the positioning module (220) is further configured to include in the first status message information that the cover (110) is open.

4. A system comprising
at least one apparatus (100, 300, 400) of any of the claims 1 to 3; and
a remote unit (810) in a communication connection with the at least one apparatus (100, 300, 400), the remote unit (810) comprising at least one processor, memory including computer program code, the memory and the computer program code configured to, with the at least one processor, cause the remote unit to
receive a status message comprising at least the positioning information of the at least one voltage detection means (100, 300, 400);
**characterized in that** the remote unit is further caused to determine based on the positioning information that loss of voltage has occurred in the power cord (150, 350, 450) of the device (500, 600, 700); and
deliver the positioning information of the device to a user.

5. A computer program product embodied on a non-transitory computer readable medium, comprising computer program code configured to, when executed on at least one processor, cause an apparatus of any of the claims 1 to 3 to perform:
monitoring, by a sensor unit (210), voltage in the power cord (150) of the device (500) and detecting loss of voltage in the power cord;
causing the positioning module (220) to:
be in a sleep mode when the voltage in the power cord is monitored;
activate in response to detected loss of voltage;
acquire a first positioning information of the apparatus (100); and
transmit a first status message comprising at least the first positioning information to a remote unit (810).

6. A computer program product embodied on a non-transitory computer readable medium, comprising computer program code configured to, when executed on at least one processor, cause a system of claim 4 to perform:
receive, by the remote unit, a status message comprising at least the positioning information of the at least one voltage detection means (100, 300, 400);
**characterized in that** the system is configured to perform: monitoring, by a sensor unit (210), voltage in the power cord (150, 350, 450) of the device (500, 600, 700) and detecting loss of voltage in the power cord;
causing the positioning module to
be in a sleep mode when the voltage in the power cord is monitored;
activate in response to detected loss of voltage;
acquire a first positioning information of the apparatus (100); and
transmit a first status message comprising at least the first positioning information to the remote unit (810); and **in that** the system is caused to perform:
determining, by the remote unit, based on the positioning information that loss of voltage has occurred in the power cord (150, 350, 450) of the device (500, 600, 700); and
delivering the positioning information of the device to a user.

## Patentansprüche

1. Vorrichtung (100), installierbar über einem Netzkabel einer Vorrichtung, umfassend:
eine Sensoreinheit (210), die so konfiguriert ist, dass sie Spannung im Netzkabel (150) der Vorrichtung (500) überwacht und einen Spannungsverlust im Netzkabel erfasst;
ein Positionierungsmodul (220), das konfiguriert ist, um
sich in einem Schlafmodus zu befinden, wenn die Spannung im Netzkabel überwacht wird;
sich als Reaktion auf den erfassten Spannungsverlust zu aktivieren;
eine erste Positionierungsinformation der Einrichtung (100) zu erlangen; und
eine erste Statusnachricht, die mindestens die erste Positionierungsinformation umfasst, an eine entfernte Einheit (810) zu übertragen.

2. Einrichtung (100) nach Anspruch 1, wobei
die Sensoreinheit (210) weiter so konfiguriert ist, dass sie die Wiederherstellung der Spannung im Netzkabel erfasst;
das Positionierungsmodul (220) weiter konfiguriert ist, um
als Reaktion auf die erfasste Wiederherstellung der Spannung, eine zweite Positionsinformation der Einrichtung (100) zu erfassen;
eine zweite Statusnachricht, die mindestens die zweite Positionierungsinformation umfasst, an die entfernte Einheit (810) zu übertragen;
als Reaktion auf das Übertragen der zweiten Statusnachricht, das Positionierungsmodul (220) zu deaktivieren.

3. Einrichtung (100) nach Anspruch 1 oder 2, weiter umfassend
eine Abdeckung (110);
einen Schalter (240), der so konfiguriert ist, dass er erfasst, ob die Abdeckung (110) der Einrichtung (100) offen ist; und wobei das Positionierungsmodul (220) weiter so konfiguriert ist, dass es in der ersten Statusnachricht Informationen einschließt, dass die Abdeckung (110) offen ist.

4. System, umfassend
mindestens eine Einrichtung (100, 300, 400) nach einem der Ansprüche 1 bis 3; und eine entfernte Einheit (810), die in einer Kommunikationsverbindung mit der mindestens einen Einrichtung (100, 300, 400) steht, wobei die entfernte Einheit (810) mindestens einen Prozessor, einen Speicher, der Computerprogrammcode einschließt, umfasst, wobei der Speicher und der Computerprogrammcode konfiguriert sind, um, mit dem mindestens einen Prozessor, zu veranlassen, dass die entfernte Einheit eine Statusnachricht empfängt, die mindestens die Positionierungsinformation des mindestens einen Spannungserfassungsmittels (100, 300, 400) umfasst;
**dadurch gekennzeichnet, dass**
das System weiter veranlasst wird, um
basierend auf der Positionierungsinformation zu bestimmen, dass Spannungsverlust im Netzkabel (150, 350, 450) der Vorrichtung (500, 600, 700) aufgetreten ist; und
die Positionierungsinformation der Vorrichtung an einen Benutzer zu liefern.

5. Computerprogrammprodukt, das auf einem nichtflüchtigen computerlesbaren Medium verkörpert ist, das Computerprogrammcode umfasst, der konfiguriert ist, um, wenn er auf mindestens einem Prozessor ausgeführt wird, zu veranlassen, dass eine Einrichtung nach einem der Ansprüche 1 bis 3 Folgendes durchführt:
Überwachen, durch eine Sensoreinheit (210), der Spannung im Netzkabel (150) der Vorrichtung (500) und Erfassen des Spannungsverlusts im Netzkabel;
Veranlassen, dass das Positionierungsmodul (220):
sich in einem Schlafmodus befindet, wenn die Spannung im Netzkabel überwacht wird;
sich als Reaktion auf einen erfassten Spannungsverlust aktiviert;
eine erste Positionierungsinformation der Einrichtung (100) erlangt; und
eine erste Statusnachricht, die mindestens die erste Positionierungsinformation umfasst, an eine entfernte Einheit (810) überträgt.

6. Computerprogrammprodukt, das auf einem nichtflüchtigen computerlesbaren Medium verkörpert ist, das Computerprogrammcode umfasst, der konfiguriert ist, um, wenn er auf mindestens einem Prozessor ausgeführt wird, zu veranlassen, dass ein System nach Anspruch 4 Folgendes durchführt:
Empfangen, durch die entfernte Einheit, einer Statusnachricht, die mindestens die Positionierungsinformation des mindestens einen Spannungserfassungsmittels (100, 300, 400) umfasst;
**dadurch gekennzeichnet, dass** das System konfiguriert ist, um Folgendes durchzuführen:
Überwachen, durch eine Sensoreinheit (210), der Spannung im Netzkabel (150, 350, 450) der Vorrichtung (500, 600, 700) und Erfassen des Spannungsverlusts im Netzkabel;
wobei das Positionierungsmodul veranlasst wird, um
sich in einem Schlafmodus zu befinden, wenn die Spannung im Netzkabel überwacht wird;
sich als Reaktion auf einen erfassten Spannungsverlust zu aktivieren;
eine erste Positionierungsinformation der Einrichtung (100) zu erlangen; und
eine erste Statusnachricht, die mindestens die erste Positionierungsinformation umfasst, an die entfernte Einheit (810) zu übertragen; und dadurch, dass das System veranlasst wird, Folgendes durchzuführen:
Bestimmen, durch die entfernte Einheit, basierend auf der Positionierungsinformation, dass Spannungsverlust in dem Netzkabel (150, 350, 450) der Vorrichtung (500, 600, 700) aufgetreten ist; und
Liefern der Positionierungsinformation der Vorrichtung an einen Benutzer.

## Revendications

1. Appareil (100) pouvant être installé sur un cordon d'alimentation d'un dispositif, comprenant :
une unité de capteur (210) configurée pour surveiller la tension dans le cordon d'alimentation (150) du dispositif (500) et pour détecter une perte de tension dans le cordon d'alimentation ;
un module de positionnement (220) configuré pour
être en mode veille lorsque la tension du cordon d'alimentation est surveillée ;
s'activer en réponse à la perte de tension détectée ;
acquérir une première information de positionnement de l'appareil (100) ; et
transmettre un premier message d'état comprenant au moins la première information de positionnement à une unité distante (810).

2. Appareil (100) selon la revendication 1, dans lequel
l'unité de capteur (210) est en outre configurée pour détecter le rétablissement d'une tension dans le cordon d'alimentation ;
le module de positionnement (220) est en outre configuré pour
acquérir, en réponse au rétablissement détecté d'une tension, une seconde information de positionnement de l'appareil (100) ;
transmettre un deuxième message d'état comprenant au moins la seconde information de positionnement à l'unité distante (810) ;
désactiver, en réponse à la transmission du second message d'état, le module de positionnement (220).

3. Appareil (100) selon la revendication 1 ou 2, comprenant en outre
un couvercle (110);
un commutateur (240) configuré pour détecter si le couvercle (110) de l'appareil (100) est ouvert ; et dans lequel le module de positionnement (220) est en outre configuré pour inclure dans le premier message d'état des informations indiquant que le couvercle (110) est ouvert.

4. Système comprenant
au moins un appareil (100, 300, 400) selon l'une quelconque des revendications 1 à 3 ; et une unité distante (810) dans une connexion de communication avec l'au moins un appareil (100, 300, 400), l'unité distante (810) comprenant au moins un processeur, une mémoire incluant un code de programme informatique, la mémoire et le code de programme informatique étant configurés pour, avec le au moins un processeur, amener l'unité distante à recevoir un message d'état comprenant au moins les informations de positionnement du au moins un moyen de détection de tension (100, 300, 400) ;
**caractérisé en ce que**
le système est en outre amené à
déterminer sur la base des informations de positionnement qu'une perte de tension s'est produite dans le cordon d'alimentation (150, 350, 450) du dispositif (500, 600, 700) ; et
fournir les informations de positionnement du dispositif à un utilisateur.

5. Produit de programme informatique incorporé sur un support non transitoire lisible par ordinateur, comprenant un code de programme informatique configuré pour, lorsqu'il est exécuté sur au moins un processeur, amener un appareil selon l'une quelconque des revendications 1 à 3 à exécuter l'action suivante :
surveiller, par une unité de capteur (210), la tension dans le cordon d'alimentation (150) du dispositif (500) et détecter une perte de tension dans le cordon d'alimentation ;
amenant le module de positionnement (220) à :
être en mode veille lorsque la tension du cordon d'alimentation est surveillée ;
s'activer en réponse à une perte de tension détectée ;
acquérir une première information de positionnement de l'appareil (100) ; et
transmettre un premier message d'état comprenant au moins les premières informations de positionnement à une unité distante (810).

6. Produit de programme informatique incorporé sur un support non transitoire lisible par ordinateur, comprenant un code de programme informatique configuré pour, lorsqu'il est exécuté sur au moins un processeur, amener un système selon la revendication 4 à exécuter l'action suivante :
recevoir, par l'unité distante, un message d'état comprenant au moins les informations de positionnement du au moins un moyen de détection de tension (100, 300, 400) ;
**caractérisé en ce que** le système est configuré pour effectuer l'action suivante :
surveiller, par une unité de capteur (210), la tension dans le cordon d'alimentation (150, 350, 450) du dispositif (500, 600, 700) et détecter la perte de tension dans le cordon d'alimentation ;
amenant le module de positionnement à
être en mode veille lorsque la tension du cordon d'alimentation est surveillée ;
s'activer en réponse à une perte de tension détectée ;
acquérir une première information de positionnement de l'appareil (100) ; et
transmettre un premier message d'état comprenant au moins les premières informations de positionnement à l'unité distante (810) ; et **en ce que** le système est amené à effectuer les actions suivantes :
déterminer, par l'unité distante, sur la base des informations de positionnement, qu'une perte de tension s'est produite dans le cordon d'alimentation (150, 350, 450) du dispositif (500, 600, 700) ; et
fournir les informations de positionnement du dispositif à un utilisateur.
